# EUROPEAN PATENT APPLICATION

(11) **EP 4 850 821 A1**
(43) Date of publication of application: **09.12.2026**
(21) Application number: 26183164.8
(22) Date of filing: 04.06.2026
(51) Int. Cl.: B05C 11/08, B05C 13/02, B05D 1/00, G03F 7/16

(54) **SPIN COATER DEVICE FIXTURE AND METHOD**

(30) Priority: 04.06.2025 US 202519228369
(71) Applicant: RTX Corporation, Farmington, CT 06032 (US)
(72) Inventor: BUTCHER, Evan J., Suffield, 06078 (US); McCLUNG, Andrew, Florence, 01062 (US); CALDWELL, Dustin D., Portland, 06480 (US); KENNEDY, Zachary, Hamden, 06514 (US)
(74) Representative: Dehns

(57) **Abstract**

A component fixture (22) for a spin coating device (20) is provided that includes a base (32) and a cover (34). The base (32) includes a body (36) and a stem (38). The body (36) includes a first section (36A) that is symmetric about the rotational axis (40) and an interior compartment (48) that has an open end disposed at a first end (42). The stem (38) extends from a second end (44) of the base (32) to the body (36). The stem (38) is symmetric about the rotational axis (40) and is configured to engage with a drive chuck (30). The cover (34) is configured to couple with the base (32) at the open end (42) of the body (36). A portion of the cover (34) extends into the interior compartment (48). The cover (34) includes an aperture (74) disposed in an exterior surface (70A). The cover (34) is configured to mount a component such that the component is received in the aperture (74) and a surface of the component is disposed for coating.

## Description

### BACKGROUND OF THE INVENTION

### 1. Technical Field

This invention relates to spin coating processes in general, and to fixtures for spin coating processes in particular.

### 2. Background Information

A spin coating procedure may be used to deposit a uniform thin film onto a flat substrate. A small amount of coating material in liquid form is applied to the center of the substrate. The substrate is subsequently rotated at high speed (e.g., up to 10,000 rpm) to spread the coating material by centrifugal force. During the coating process, the coating fluid migrates radially outward. As the spinning process continues, the coating fluid now covering the substrate decreases in thickness until the desired coating thickness is achieved. Excess coating fluid is expelled from the edges of the substrate during the coating process.

### SUMMARY OF THE INVENTION

According to an aspect of the present invention, a component fixture for a spin coating device is provided. The spin coating device includes a drive chuck. The component fixture includes a base and a cover. The base extends axially along a rotational axis between a first end and a second end. The base includes a body and a stem. The body includes a first section that is symmetric about the rotational axis and an interior compartment that has an open end disposed at the first end. The stem extends from the second end of the base to the body. The stem is symmetric about the rotational axis. The stem is configured to engage with the drive chuck. The cover is configured to couple with the base at the open end of the body. A portion of the cover extends into the interior compartment. The cover includes an aperture disposed in an exterior surface. The cover is configured to mount a component such that the component is received in the aperture and a surface of the component is disposed for coating.

Optionally, and in accordance with the above, the body may include an enclosed second section disposed opposite the open end of the interior compartment, and the interior compartment may extend between the enclosed second section and the open end.

Optionally, and in accordance with any of the above, the enclosed second section of the body may have a convergent configuration.

Optionally, and in accordance with any of the above, a perimeter wall may define the first section and the enclosed second section, and the interior compartment.

Optionally, and in accordance with any of the above, the first section may have a cylindrical configuration.

Optionally, and in accordance with any of the above, an attachment mechanism may be used to couple the cover and the base. The base may include a first portion of the attachment mechanism and the cover may include a second portion of the attachment mechanism.

Optionally, and in accordance with any of the above, the cover may include an end panel and a cover perimeter wall. When the cover is attached to the base, the end panel may be perpendicular to the rotational axis, and the cover perimeter wall may extend axially.

Optionally, and in accordance with any of the above, the cover perimeter wall may be configured to mate with the body at the open end.

Optionally, and in accordance with any of the above, the end panel of the cover may include the exterior surface in which the aperture is disposed.

Optionally, and in accordance with any of the above, the fixture may further include a wafer configured for engagement with the end panel of cover. The wafer may include a second aperture configured to receive the component.

Optionally, and in accordance with any of the above, the cover may include a cable reel.

Optionally, and in accordance with any of the above, the cover may include an end panel and a cover perimeter wall, and the cable reel may be mounted to the end panel by a post.

Optionally, and in accordance with any of the above, when the cover is coupled with the base, the cable reel may be disposed within the interior compartment.

Optionally, and in accordance with any of the above, the stem may include a center passage that is in fluid communication with the interior compartment.

Optionally, and in accordance with any of the above, the base may be comprised of a homogeneous material.

Optionally, and in accordance with any of the above, the base may be formed using an additive manufacturing process.

According to another aspect of the present invention, a method for depositing a coating to a component surface using a spin coating device is provided. The method includes: providing a component fixture that includes a base and a cover, wherein the base includes a body that has a first section that is symmetric about a rotational axis, and an interior compartment having an open end, and a stem that is symmetric about the rotational axis, and wherein the cover is configured to couple with the base at the open end of the body; mounting a component on the cover such that a surface of the component to be coated is exposed at an exterior surface of the cover; attaching the cover to the base so that a portion of the component that is to remain uncoated is disposed within the interior compartment of the base; engaging the component fixture with the spin coating device; applying a coating material on the surface of the component to be coated; and rotating fixture and component about the rotational axis until the coating is deposited uniformly to the surface of the component.

Optionally, and in accordance with the above, the component may be a fiber optic connector assembly that includes an array lid and base and a cladded cable.

Optionally, and in accordance with any of the above, the cover may include an end panel, a cover perimeter wall, and a cable reel, and the step of mounting the component on the cover may include mounting the fiber optic connector assembly such that a surface of the array lid and base is exposed at the exterior surface of the cover, and the mounting includes wrapping the cladded cable around the cable reel.

Optionally, and in accordance with any of the above, the cover may include an end panel, a cover perimeter wall, a cable reel, and a wafer, and the step of mounting the component on the cover may include mounting the fiber optic connector assembly such that a surface of the array lid and base is exposed at the exterior surface of the wafer, and includes wrapping the cladded cable around the cable reel.

The foregoing features and elements may be combined in various combinations without exclusivity, unless expressly indicated otherwise. For example, aspects and/or embodiments of the present invention may include any one or more of the individual features or elements disclosed above and/or below alone or in any combination thereof. These features and elements as well as the operation thereof will become more apparent in light of the following description and the accompanying drawings. The following description and drawings are intended to be exemplary in nature and non-limiting.

### BRIEF DESCRIPTION OF THE DRAWINGS

FIG. 1 is a diagrammatic view of an aircraft powerplant.
FIG. 2 is a diagrammatic illustration of a component to be coated, in the form of a fiber optic connector assembly.
FIG. 3 is an enlarged view of a portion of the fiber optic connector assembly shown in FIG. 2.
FIG. 4 is a diagrammatic view of the base of a present invention spin coater fixture embodiment.
FIG. 5 is a diagrammatic sectional view of the stem of the spin coater fixture embodiment shown in FIG. 4.
FIG. 6 is a diagrammatic view of the cover of a present invention spin coater fixture embodiment.
FIG. 7A is a diagrammatic sectional view of a portion of a cover embodiment.
FIG. 7B is a diagrammatic sectional view of a portion of a cover embodiment.
FIG. 7C is a diagrammatic sectional view of a portion of a cover embodiment.
FIG. 8 is a diagrammatic view of a present invention cover with a component mounted thereto.

### DETAILED DESCRIPTION

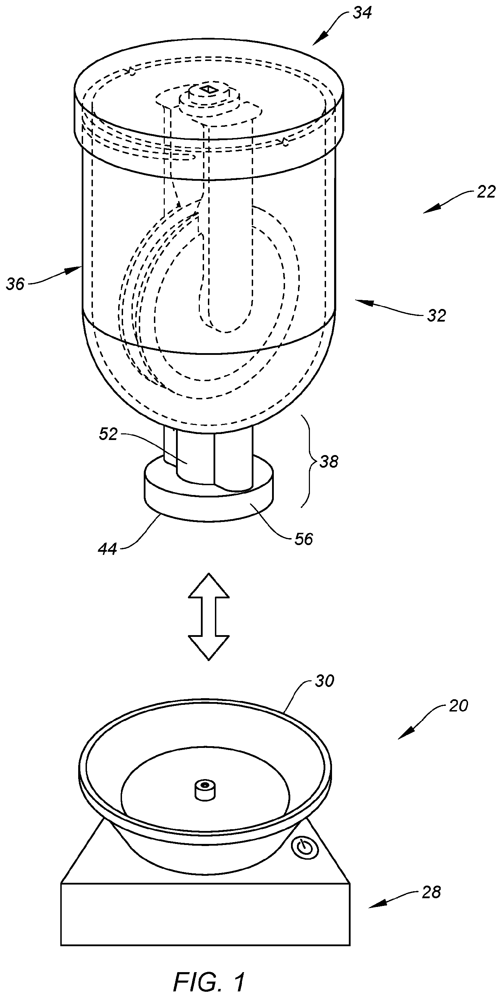

FIG. 1 is a diagrammatic representation of a spin coater device 20 and an embodiment of a present invention spin coater fixture 22.

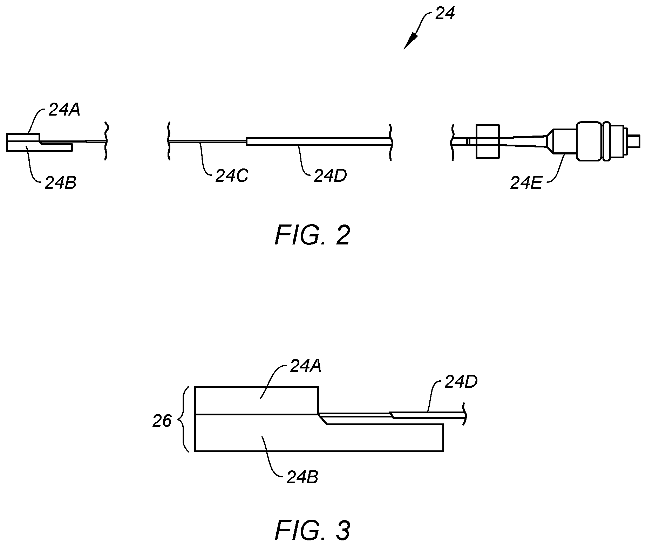

Embodiments of the present invention spin coater fixture 22 may be configured to coat a surface of a component. A non-limiting example of such a component is a fiber optic connector assembly. FIG. 2 diagrammatically illustrates an example of a fiber optic connector assembly 24 that includes an array lid 24A and base 24B, bare fibers 24C (shown for illustration sake), a cladded cable 24D, and a cable connector 24E. FIG. 3 illustrates an enlarged view of the array lid 24A and base 24B shown in FIG. 2. The end surface 26 of the array lid and base 24A, 24B can be seen in FIG. 3. A fiber optic connector assembly 24 of this type may be used with ultrasonic testing equipment used to inspect components such as a rotor disk used within a gas turbine engine.

The spin coater device 20 includes a housing 28, a drive chuck 30, and a drive motor (not shown). The drive motor is configured to rotationally drive the drive chuck 30 at selected rotational speeds. The present invention is not limited to any particular spin coater device 20 configuration, other than one that is compatible with the present invention spin coater fixture 22.

Some present invention spin coater fixture 22 embodiments include a base 32 and a cover 34. In FIG. 1, the cover 34 is shown attached to the base 32. The portions of the cover 34 disposed within the base 32 (not visible in assembled form) are shown in dashed lines.

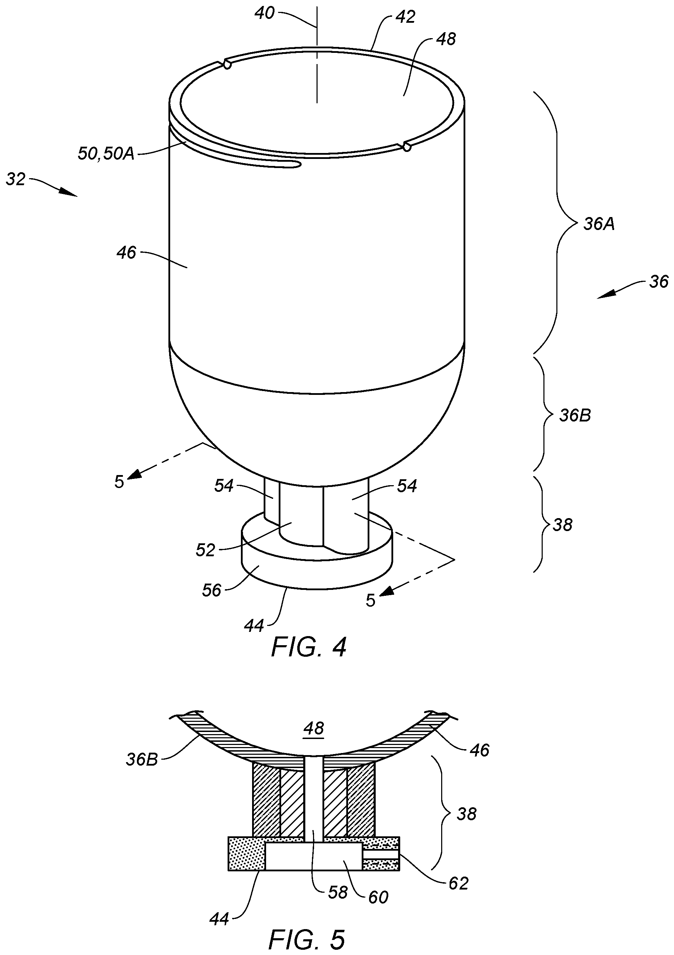

Referring to FIG. 4, the base 32 includes a body 36, a stem 38, and a rotational axis 40 of the base 32. The base 32 extends axially between a first end 42 and a second end 44. The body 36 includes an perimeter wall 46 that defines an interior compartment 48. The body 36 includes a first section 36A that is symmetrical about the rotational axis 40 of the base 32. In some embodiments, the first section 36A may have a cylindrical configuration. The present invention is not, however, limited to a cylindrical first section 36A. In some embodiments, the body 36 may include a convergent second section 36B. The convergent second section 36B is disposed axially between the first section 36A of the body 36 and the stem 38 of the base 32. The convergent second section 36B may have a hemispherical configuration. The convergent second section 36B forms an enclosed end of the body 36.

In some embodiments, the fixture 22 may include a cover attachment mechanism 50. The body 36 of the base 32 may include a first portion 50A of the cover attachment mechanism 50 and the cover 34 may include a second portion 50B of the cover attachment mechanism 50. An example of a cover attachment mechanism 50 is a helical feature that receives, or extends into, a mating feature disposed with the cover 34.

Referring to FIGS. 4 and 5, the stem 38 extends between the second end 44 of the base 32 to the convergent second section 36B of the body 36. The stem 38 embodiment shown in FIGS. 4 and 5 includes a shaft segment 52 with lateral wings 54 and a stem plate 56. The shaft segment 52 and lateral wings 54 extend between the stem plate 56 and the convergent second section 36B of the body 36. In some embodiments, the stem 38 may include a center passage 58 that provides a fluid passage into the interior compartment 48 through the stem 38; e.g., to permit creation of a vacuum environment within the interior compartment 48. A cavity 60 is disposed in the stem plate 56. The cavity 60 is configured to receive the drive chuck 30 of the spin coater device 20. In some embodiments, the cavity 60 may asymmetrically mate with the drive chuck 30 to facilitate engagement between the drive chuck 30 and the spin coater fixture 22. In some embodiments (e.g., like that shown in FIG. 5), the stem plate 56 may include a set screw 62 to facilitate maintaining engagement between the spin coater fixture 22 and the drive chuck 30. The present invention is not limited to the stem 38 embodiment shown in FIGS. 4 and 5.

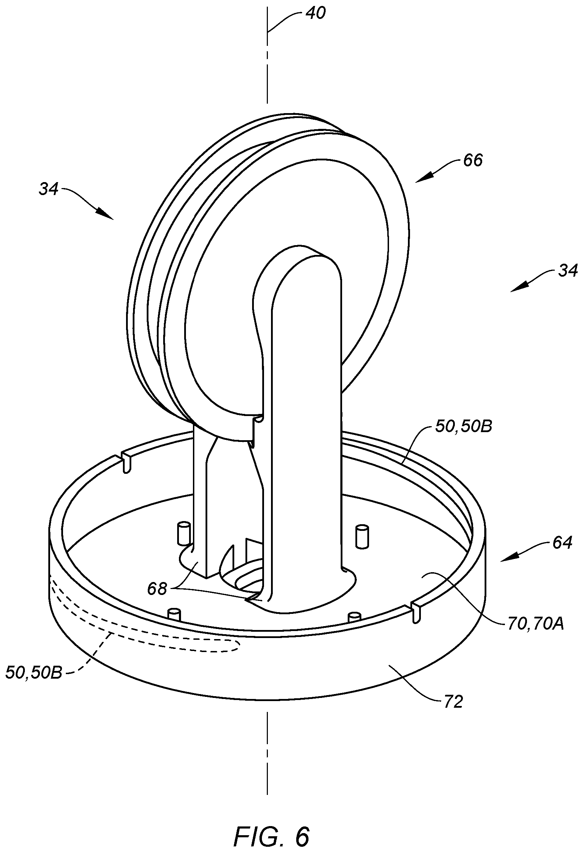

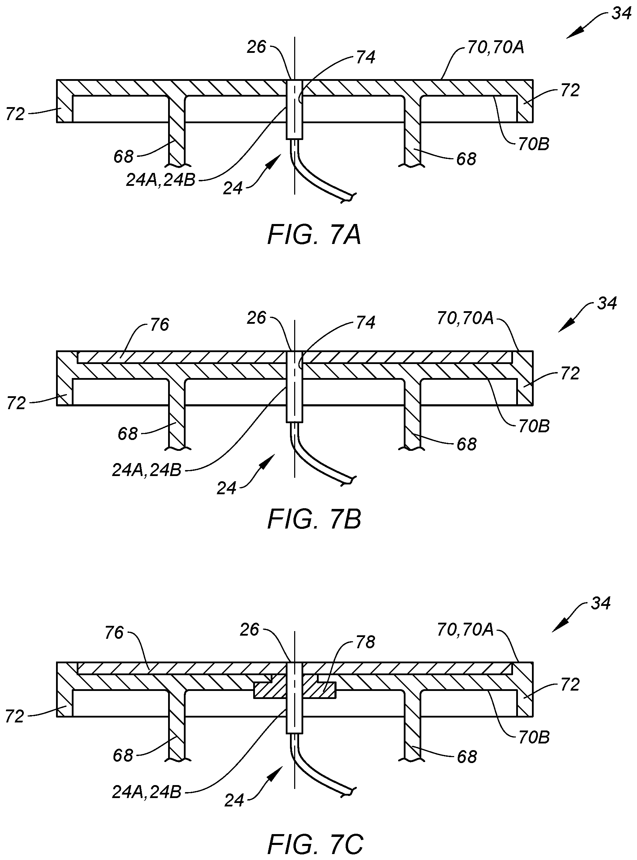

FIG. 6 illustrates a cover 34 embodiment that is shown inverted to facilitate the description herein. The cover 34 includes a cap 64 and a cable reel 66. A pair of posts 68 are utilized to mount the cable reel 66 to the cap 64. The cover 34 embodiment shown in FIGS. 6 and 7A-7C have a cap 64 with a circular configuration that mates with the body 36 of the base 32 at the first end 42 of the base 32; i.e., at the open end of the body 36. The present invention is not limited to a cap 64 or a base body 36 having a circular configuration; e.g., other symmetrical configurations may be used.

Referring to FIGS. 7A-7C, the cap 64 includes an end panel 70 and a perimeter wall 72, and has a rotational axis (same rotational axis 40 as the base 32 when combined) shown in dashed line. The end panel 70 has an exterior surface 70A and an opposing interior surface 70B. In some embodiments, the end panel 70 may be configured to mount a component for spin coating. In other embodiments, the component may be mounted to a structure other than the end panel 70. Either way, the end panel 70 will include an aperture 74 (e.g., see FIGS. 7A and 7B) for receiving at least a portion of the component to be coated. The perimeter wall 72 extends around the periphery of the end panel 70 (e.g., in a circular configuration) and extends axially outward from the interior surface 70B of the end panel 70.

In the cap 64 embodiment shown in FIG. 7A, the end panel 70 is configured to mount a component (e.g., an end surface 26 of the array lid and base 24A, 24B of a fiber optic connector assembly 24) for spin coating; e.g., see FIG. 3. The array lid and base 24A, 24B of the fiber optic connector assembly 24 are diagrammatically shown in FIG. 7A with the end surface 26 disposed flush with the exterior surface 70A of the end panel 70. The posts 68 are shown extending axially outward from the interior surface 70B of the end panel 70.

In the cap 64 embodiment shown in FIG. 7B, the end panel 70 is again configured to mount a component (e.g., the end surface 26 of the array lid and base 24A, 24B) for spin coating. In this embodiment, the cover 34 further includes a wafer 76. The wafer 76 is disposed within a cavity formed within the exterior surface 70A of the end panel 70. The surface to be spin coated (e.g., end surface 26) is flush with an exterior surface of the wafer 76. In alternative embodiments, the wafer 76 may extend across the entirety of the end panel 70. The wafer 76 may comprise a material that is compatible with the coating material that is to be applied in the spin coating process. For example, in those instances wherein a coating of SU-8 is to be applied, the wafer 76 may also comprise an SU-8 material. SU-8 is an epoxy-based negative photoresist material that is composed of Bisphenol A Novalac epoxy that is dissolved in an organic solvent and up to 10 wgt% of mixed Triarylsulfonium/hexafluoroantimonate salt. SU-8 is an example of a wafer 76 material and the present invention is not limited to any particular wafer 76 material.

In the cap 64 embodiment shown in FIG. 7C, the cover 34 includes a wafer 76 as described above regarding FIG. 7B. In this embodiment, the cap 64 includes an adapter 78 that is configured to mount the component to the end panel 70. The adapter 78 allows the same cover 34 to be used to coat a variety of different components; e.g., different adapters 78 can be configured to appropriately mount different components for spin coating.

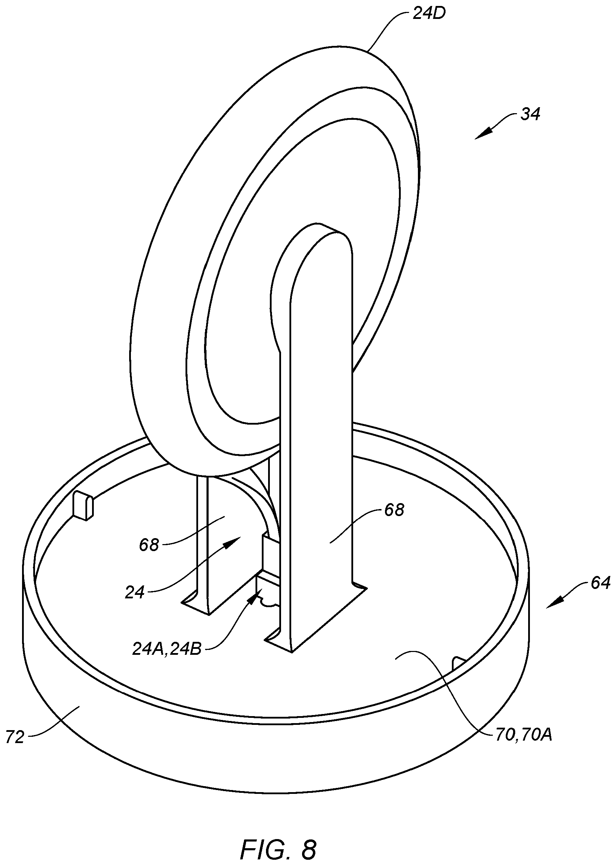

The cover 34 configuration illustrated in FIGS. 1, 6, and 8 includes a cable reel 66 that is configured to accept a plurality of wraps of a fiber optic cable. Fiber optic cable typically has a minimum bend radius to avoid cable damage. The cable reel 66 diameter may be chosen in view of the minimum bend radius and the amount of fiber optic cable that is included in the fiber optic connector assembly 24. In some embodiments, the cable reel 66 may be rotationally mounted. FIG. 8 diagrammatically illustrates a fiber optic connector assembly 24 mounted on a cover 34, with the array lid and base 24A, 24B mounted relative to the end panel 70 to position the end surface 26 for coating, and the fiber optical cable is wrapped around the cable reel 66.

As part of a spin coating process using the present invention spin coater fixture 22, the base 32 portion of the spin coater fixture 22 may be mounted on the spin coater device 20 to permit the spin coater fixture 22 to be rotationally driven; e.g., the drive chuck 30 of the spin coater may be received within the cavity disposed within the stem 38. If the embodiment includes a set screw 62 (e.g., see FIG. 5), the set screw 62 may be operated to secure the spin coater fixture 22 to the drive chuck 30.

In those instances wherein it is desirable to apply a coating to the end surface 26 of the array lid and base 24A, 24B of a fiber optic connector assembly 24, the array lid and base 24A, 24B may be mounted to the end panel 70 of the cap 64. The fiber optic cladded cable 24D of the fiber optic connector assembly 24 is wrapped around the cable reel 66 and secured. The cable reel 66 may then be inserted into the interior compartment 48 of the body 36 of the base 32 and secured to the base 32. In those embodiments, where the fixture 22 includes a cover attachment mechanism 50, the cover 34 can be attached to the base 32 via the attachment mechanism.

Once the component (e.g., the fiber optic connector assembly 24 is secured to the cover 34 and the cover 34 is secured to the base 32, the coating material can be applied to the surface to be coated. The coating material to be applied is typically in a liquid form and the surface to be coated is aligned with the rotational axis 40 of the fixture 22. In some embodiments, a vacuum environment may be created within the interior compartment 48 of the base 32; e.g., via center passage 58 to secure a wafer 76.

The present invention is not limited to any particular coating procedure. A conventional spin coating method includes depositing the liquid coating on the central portion of the surface to be coated. The coating material may be deposited when the fixture 22 and the component are stationary, or when they are rotating at a relatively low rotational speed. Once the coating material is deposited, the fixture 22 and component are rotated at a high rotational speed. During the rotation, the coating material spreads radially outward from the center of the component due to centrifugal force and the coating material is subsequently applied to the entire substrate. The thickness of the applied coating may be a function of the fixture rotational speed; i.e., the higher the rotational speed the thinner the thickness of the coating.

While the principles of the invention have been described above in connection with specific apparatuses and methods, it is to be clearly understood that this description is made only by way of example and not as limitation on the scope of the invention. Specific details are given in the above description to provide a thorough understanding of the embodiments. However, it is understood that the embodiments may be practiced without these specific details.

It is noted that the embodiments may be described as a process which is depicted as a flowchart, a flow diagram, a block diagram, etc. Although any one of these structures may describe the operations as a sequential process, many of the operations can be performed in parallel or concurrently. In addition, the order of the operations may be rearranged. A process may correspond to a method, a function, a procedure, a subroutine, a subprogram, etc.

The singular forms "a," "an," and "the" refer to one or more than one, unless the context clearly dictates otherwise. For example, the term "comprising a specimen" includes single or plural specimens and is considered equivalent to the phrase "comprising at least one specimen." The term "or" refers to a single element of stated alternative elements or a combination of two or more elements unless the context clearly indicates otherwise. As used herein, "comprises" means "includes." Thus, "comprising A or B," means "including A or B, or A and B," without excluding additional elements.

It is noted that various connections are set forth between elements in the present description and drawings (the contents of which are included in this invention by way of reference). It is noted that these connections are general and, unless specified otherwise, may be direct or indirect and that this specification is not intended to be limiting in this respect. Any reference to attached, fixed, connected or the like may include permanent, removable, temporary, partial, full and/or any other possible attachment option.

No element, component, or method step in the present invention is intended to be dedicated to the public regardless of whether the element, component, or method step is explicitly recited in the claims. As used herein, the terms "comprise", "comprising", or any other variation thereof, are intended to cover a non-exclusive inclusion, such that a process, method, article, or apparatus that comprises a list of elements does not include only those elements but may include other elements not expressly listed or inherent to such process, method, article, or apparatus.

While various inventive aspects, concepts and features of the inventions may be described and illustrated herein as embodied in combination in the exemplary embodiments, these various aspects, concepts, and features may be used in many alternative embodiments, either individually or in various combinations and sub-combinations thereof. Unless expressly excluded herein all such combinations and sub-combinations are intended to be within the scope of the present application. Still further, while various alternative embodiments as to the various aspects, concepts, and features of the inventions--such as alternative materials, structures, configurations, methods, devices, and components, and so on--may be described herein, such descriptions are not intended to be a complete or exhaustive list of available alternative embodiments, whether presently known or later developed. Those skilled in the art may readily adopt one or more of the inventive aspects, concepts, or features into additional embodiments and uses within the scope of the present application even if such embodiments are not expressly disclosed herein. For example, in the exemplary embodiments described above within the Detailed Description portion of the present specification, elements may be described as individual units and shown as independent of one another to facilitate the description. In alternative embodiments, such elements may be configured as combined elements. It is further noted that various method or process steps for embodiments of the present invention are described herein. The description may present method and/or process steps as a particular sequence. However, to the extent that the method or process does not rely on the particular order of steps set forth herein, the method or process should not be limited to the particular sequence of steps described. As one of ordinary skill in the art would appreciate, other sequences of steps may be possible.

## Claims

1. A component fixture (22) for a spin coating device (20), the spin coating device (20) including a drive chuck (30), and the component fixture (22) comprising:
a base (32) that extends axially along a rotational axis (40) between a first end (42) and a second end (44), the base (32) including:
a body (36) that includes a first section (36A) that is symmetric about the rotational axis (40), the body (36) including an interior compartment (48) having an open end disposed at the first end (42); and
a stem (38) extending from the second end (44) of the base (32) to the body (36), wherein the stem (38) is symmetric about the rotational axis (40), and wherein the stem (38) is configured to engage with the drive chuck (30); and
a cover (34) that is configured to couple with the base (32) at the open end of the body (36), wherein a portion of the cover (34) extends into the interior compartment (48), and wherein the cover (34) includes an aperture (74) disposed in an exterior surface (70A), and the cover (34) is configured to mount a component such that the component is received in the aperture (74) and a surface of the component is disposed for coating.

2. The component fixture (22) according to claim 1, wherein the body (36) includes an enclosed second section (36B) disposed opposite the open end (42) of the interior compartment (48), wherein the interior compartment (48) extends between the enclosed second section (36B) and the open end (42).

3. The component fixture (22) according to claim 2, wherein:
the enclosed second section (36B) of the body (36) has a convergent configuration; and/or
a perimeter wall (46) defines the first section (36A), the enclosed second section (36B), and the interior compartment (48).

4. The component fixture (22) according to any preceding claim, wherein the first section (36A) has a cylindrical configuration.

5. The component fixture (22) according to any preceding claim, wherein an attachment mechanism (50) is used to couple the cover (34) and the base (32), wherein the base (32) includes a first portion (50A) of the attachment mechanism and the cover (34) includes a second portion (50B) of the attachment mechanism.

6. The component fixture (22) according to any preceding claim, wherein the cover (34) includes an end panel (70) and a cover perimeter wall (72), wherein when the cover (34) is attached to the base (32), the end panel (70) is perpendicular to the rotational axis (40), and the cover perimeter wall (72) extends axially.

7. The component fixture (22) according to claim 6, wherein the cover perimeter wall (72) is configured to mate with the body (36) at the open end (42).

8. The component fixture (22) of claim 6 or 7, wherein:
the end panel (70) of the cover (34) includes the exterior surface (70A) in which the aperture (74) is disposed; and/or
the fixture (22) further includes a wafer (76) configured for engagement with the end panel (70) of the cover (34), wherein the wafer (76) includes a second aperture (74) configured to receive the component.

9. The component fixture (22) of any preceding claim, wherein the cover (34) includes a cable reel (66).

10. The component fixture (22) of claim 9, wherein:
the cover (34) includes an end panel (70) and a cover perimeter wall (72), and the cable reel (66) is mounted to the end panel (70) by a post (68); and/or
when the cover (34) is coupled with the base (32), the cable reel (66) is disposed within the interior compartment (48).

11. The component fixture (22) of any preceding claim, wherein the stem (38) includes a center passage (58) that is in fluid communication with the interior compartment (48).

12. The component fixture (22) of any preceding claim, wherein the base (32) is comprised of a homogeneous material, and wherein, optionally, the base (32) is formed using an additive manufacturing process.

13. A method for depositing a coating onto a component surface using a spin coating device (20), the method comprising:
providing a component fixture (22) that includes a base (32) and a cover (34), wherein the base (32) includes a body (36) that has a first section (36A) that is symmetric about a rotational axis (40), an interior compartment (48) having an open end (42), and a stem (38) that is symmetric about the rotational axis (40), and wherein the cover (34) is configured to couple with the base (32) at the open end (42) of the body (36);
mounting a component on the cover (34) such that a surface of the component to be coated is exposed at an exterior surface (70A) of the cover (34);
attaching the cover (34) to the base (32) so that a portion of the component that is to remain uncoated is disposed within the interior compartment (48) of the base (32);
engaging the component fixture (22) with the spin coating device (20);
applying a coating material on the surface of the component to be coated; and
rotating fixture (22) and component about the rotational axis (40) until the coating is deposited uniformly to the surface of the component.

14. The method of claim 13, wherein the component is a fiber optic connector assembly (24) that includes an array lid and base (24A, 24B) and a cladded cable (24D).

15. The method of claim 14, wherein:
the cover (34) includes an end panel (70), a cover perimeter wall (72), and a cable reel (66), and the step of mounting the component on the cover (34) includes mounting the fiber optic connector assembly (24) such that a surface of the array lid and base (24A, 24B) is exposed at the exterior surface (70A) of the cover (34), and includes wrapping the cladded cable (24D) around the cable reel (66); or
the cover (34) includes an end panel (70), a cover perimeter wall (72), a cable reel (66), and a wafer (76), and the step of mounting the component on the cover (34) includes mounting the fiber optic connector assembly (24) such that a surface of the array lid and base (24A, 24B) is exposed at the exterior surface (70A) of the wafer (76), and includes wrapping the cladded cable (24D) around the cable reel (66).
